# EUROPEAN PATENT SPECIFICATION

(11) **EP 0 612 107 B1**
(45) Date of publication and mention of the grant of the patent: **30.06.1999**
(21) Application number: 93830061.3
(22) Date of filing: 19.02.1993
(51) Int. Cl.: H01L 27/115, H01L 29/788, G11C 16/04

(54) **Programming method for a double polysilicon EEPROM cell**
Programmierungsverfahren einer EEPROM-Zelle mit doppelter Polysiliziumschicht
Procédé de programmation d'une cellule EEPROM à double couche de polysilicium

(43) Date of publication of application: 24.08.1994
(73) Proprietor: STMicroelectronics S.r.l., 20041 Agrate Brianza (Milano) (IT)
(72) Inventor: Pio, Federico, I-20154 Milano (IT); Riva, Carlo, I-20055 Renate Brianza (IT)
(74) Representative: Botti, Mario

(56) References cited:
- EP-A- 0 079 636
- EP-A- 0 379 693
- US-A- 4 742 492
- US-A- 4 852 062
- US-A- 5 081 054
- JAPANESE JOURNAL OF APPLIED PHYSICS. vol. 30, no. 4, April 1991, TOKYO JP pages 627 - 632 J.-Y. KANG ET AL

## Description

### Field of Application

This invention relates to a method for programming a two-level polysilicon EEPROM memory cell, said cell being implemented in MOS technology on a semiconductor substrate with a floating gate transistor overlying a thin tunnel oxide layer and having a further control gate overlying the floating gate, with a dielectric layer therebetween, and being connected serially to a selection transistor, said cell including active regions formed by a double implant realized with two different concentrations of the same conductivity type.

### Prior Art

As is well known, EEPROM memory structures, while being of the non-volatile type, allow the information stored therein to be altered electrically both during the write and the erase phases.

In essence, EEPROMs can have the state of any memory cells altered by tunnelling electrons through a thin layer of silicon oxide.

The thin oxide region has a smaller area than the so-called floating gate whereinto the electric charge is stored.

Memory cells with the above-outlined construction are referred to as FLOTOX, and are described, for example, in an article entitled "Oxide reliability criterion for the evaluation of endurance performance of electrically erasable programmable read-only memories", Journal App. Phys. 71, No. 9, 1992.

This kind of EEPROM memories falls into two general classes: a first class provided with a single level of polysilicon, and a second class having two discrete levels of polysilicon.

Memories of the first class have an advantage in that they can be manufactured by a comparatively simple process; but the overall circuit space requirements are much higher, usually by a factor of 1.5 to 2.5.

This penalizes memories with a single level of polysilicon in all those applications which require high circuit density, e.g. in excess of one Megabit.

It should be noted here that memories of either classes, whether with one or two levels of polysilicon, use positive voltages for both writing and erasing purposes. These voltages range from 8 to 12 Volts in order to generate a sufficiently strong electric field across the thin oxide to effectively trigger the tunnel effect.

However, the use of these relatively high positive voltages may eventually result in the thin oxide layer becoming deteriorated.

A first prior art solution to realize a two-level polysilicon EEPROM memory cell is disclosed in the U.S. patent No. Us-A-5,081,054 which discloses a floating gate transistor connected serially to a selection transistor and provided with a further control gate overlying the floating gate. An intermediate dielectric layer is interposed between such gates.

A region comprising a double implant of the same dopant, at two different concentrations, is provided between the respective gate terminals of the selection transistor and the floating gate transistor.

However, in this solution the selection transistor has only one polysilicon layer and the double implant is located only between the floating gate and the selection transistor. Moreover, the double implant phase is anticipated with respect to the gate oxide formation.

Other solutions are known from U.S. patents No. US-A-4,852,062 and No. US-A-4,742,492 which however both relate to a EPROM cell without the selection transistor.

Moreover, these last solutions do not suit low supply voltage applications and deterioration of the thin tunnel oxide is not reduced.

The underlying technical problem of this invention is to provide a programming method for a two-level polysilicon EEPROM cell which has such structural and functional features as to enhance the reliability and lifelong of storage circuits implemented with such cells, while reducing the tunnel oxide deterioration.

Another object of this invention is to enable very high density integrated storage circuits so that such circuits may be produced in a much smaller circuit area, for a given technology. This is apt to drastically lower the manufacturing costs for high density storage circuits.

### Summary of the Invention

The solutive idea on which this invention is based consists in providing a novel cell programming method which allows the voltages applied across the thin tunnel oxide layer to be distributed.

Based on that solutive idea, the technical problem is solved by the programming method as defined in Claim 1.

The features and advantages of a memory cell programming method according to the invention will become apparent from the following description of an embodiment thereof, given by way of example and not of limitation with reference to the accompanying drawings.

### Brief Description of the Drawings

In the drawings:
- Figure 1 is a top plan view showing schematically the layout of a memory cell suitable for this invention;
- Figure 2 is an enlarged scale, schematic view showing, in a vertical section taken along line II-II in Figure 1, a semiconductor portion on which the cell suitable for this invention has been formed;
- Figure 3 is an enlarged scale, schematic view showing a vertical section through that same semiconductor portion but taken along line III-III in Figure 1;
- Figures 4 to 6 are respective schematic views showing, in vertical section and time succession, the initial steps of the manufacturing process to yield a pair of the cells shown in Figure 1;
- Figures 7 to 9 are respective schematic views showing, in vertical section and time succession, the final steps of the manufacturing process to yield a pair of the cells for this invention;
- Figures 10 to 12 are respective schematic graphs showing the patterns of programming impulses versus time, during the cell write phase;
- Figures 13 and 14 are respective schematic graphs showing the patterns of programming impulses versus time, during the cell erase phase; and,
- Figures 15 to 18 are respective schematic graphs showing the patterns versus time of impulses applied to the cell during the read phase.

### Detailed Description

With reference to the drawing views, generally and schematically shown at 1 is an EEPROM memory cell suitable for this invention. Understandably, the cell 1 would be a basic component of an integrated storage circuit incorporating thousands of identical cells in a matrix.

The structure of this cell 1 will next be described with cross reference to the steps of its manufacturing process.

The cell 1 is of the so-called two-level polysilicon type and has a basic structure which is consistent with a Flash cell of the ETOX type. In essence, the core of the memory cell comprises a MOS transistor having a floating gate 12 where the electric charge is stored which allows identification of the two discrete cell states of "write" and "erase".

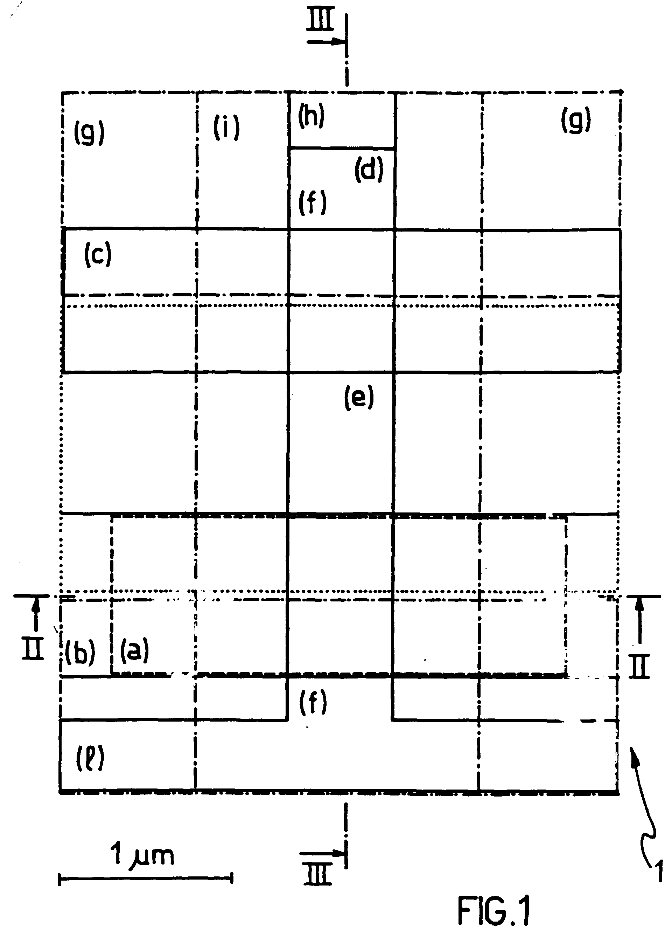

The floating gate 12 is represented in Figure 1 by a region (a) contoured by a dash line.

Provided above the floating gate 12 is a control gate electrode 15 comprising two overlapping layers of polysilicon 9 and silicide 13. In Figure 1, the control gate is represented by a region (b).

The control gate 15 is coupled capacitively to the floating gate 12 through an intervening dielectric layer 11, referred to as the interpoly layer. A voltage is transferred through this dielectric layer 11 to the floating gate 12 from the control gate 15 during the cell 1 write and/or erase phases.

Advantageously, the control gate electrode 15 is shared by all the cells forming one row or domain in the integrated storage circuit.

Connected serially to the cell 1 is a so-called selection transistor 14 which is designed to only operate at low voltages in the 5 to 7 Volts range. Region (c) in Figure 1 shows the location of this transistor 14.

The gate of this transistor 14 is also formed of a double layer of polysilicon 9 and silicide 13, and is shared by all the cells in one row of the integrated matrix.

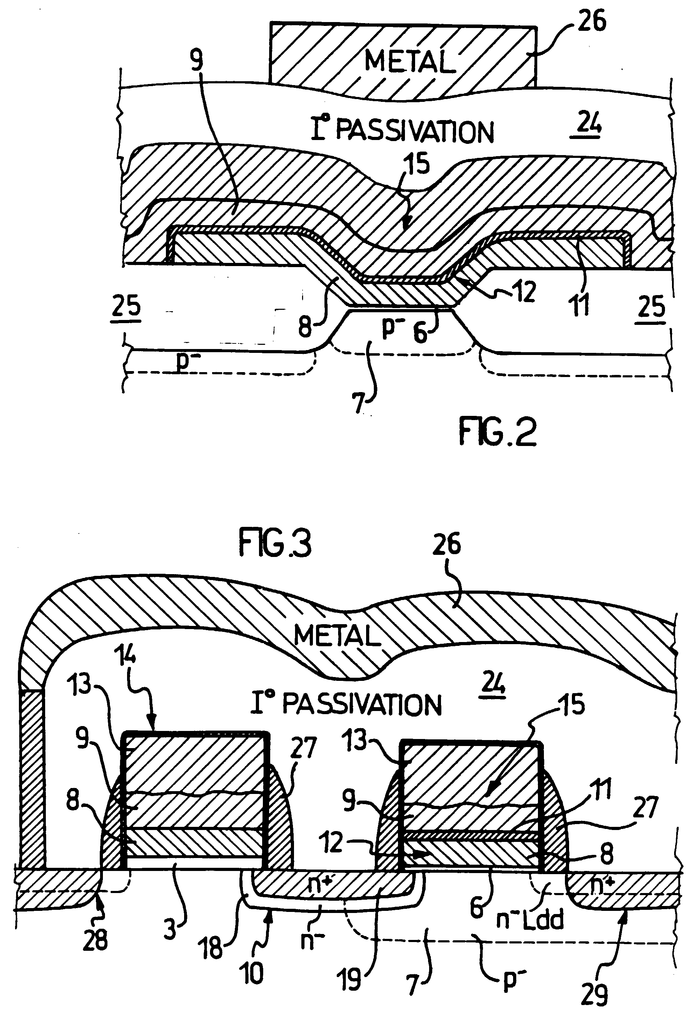

Associated with the transistor 14 are active areas 20, shown in Figure 3 and indicated in Figure 1 by a region (d).

Advantageously, provided between the respective gate terminals of the selection transistor 14 and the cell 1 is a region 10 which has at least a double implant of the same dopant at two different concentrations thereof.

In the instance considered, the dopant is of the N type and the implantation is effected using Phosphorus and Arsenic ions. Such a dual implant has shown to be specially effective to keep the so-called band-to-band (BTB) current low during the cell write phase.

In Figure 1, the region 10 is denoted by the character (e) and circumscribed by a dot line. This region 10 is formed by carrying out a first Phosphorus implantation at a low concentration of dopant N- and a subsequent implantation of Arsenic N+ at a greater concentration. Advantageously, the transistor forming the cell 1 has respective drain 28 and source 29 active regions, each with the same construction as region 10.

The reference character (f) denotes in Figure 1 the drain and source regions of the cell 1. Indicated at (h) is, moreover, a drain contact between the cell 1 and an overlying cell, not shown because symmetrical with that described herein.

The reference character (i) denotes an interconnection metallic line between the drain contacts of cells in the same column of the cell matrix which makes up the integrated storage circuit. Lastly, the reference character (l) denotes a line interconnecting the source regions which is shared by all the cells in the same row or domain of the matrix. This interconnection line (l) is also common to the source regions in the underlying row of symmetrical cells within the integrated circuit matrix.

Steps of the process for manufacturing memory cells for the invention will now be described in detail.

The cell 1 is formed on a semiconductor substrate 2 with a 0.8 µm technology and having a control gate-to-floating gate capacitive coupling of about 0.6-0.7.

A gate oxide layer 3 is grown on the surface 2a of the substrate 2 by thermal oxidation. This layer 3 is specifically intended for the selection transistor 14.

Using a conventional photolithographic technique whereby a layer 4 of a photoresist is deposited over the oxide 3, followed by wet etching, an aperture 5 is cut in the oxide layer 3 as shown in Figure 5. This aperture 5 will substantially expose again the surface 2a of the substrate 2.

Simultaneously therewith, an elongate channel region 7 which extends to beneath the opposite edges of the layer 3 is formed, proximate to the surface 2a, beneath the aperture 5 by ion implantation. The implantation is carried out using Boron ions to provide doping of the P- type in the region 7.

At this time, a thin oxide layer 6, referred to as the tunnel oxide hereinafter, is grown by thermal oxidation within the aperture 5. This tunnel oxide 6 is bounded laterally by opposite field oxide regions 25, as shown in Figure 2 and denoted in Figure 1 by the reference character (g).

The field oxide 25 delimits the active areas of the transistor with respect to the gate terminal.

Subsequent processing steps, known per se, will provide first 8 and second 9 polysilicon layers intended for the structures of the floating gate 12 and the associated control gate 15 of the cell 1, as well as of the gate of the selection transistor 14.

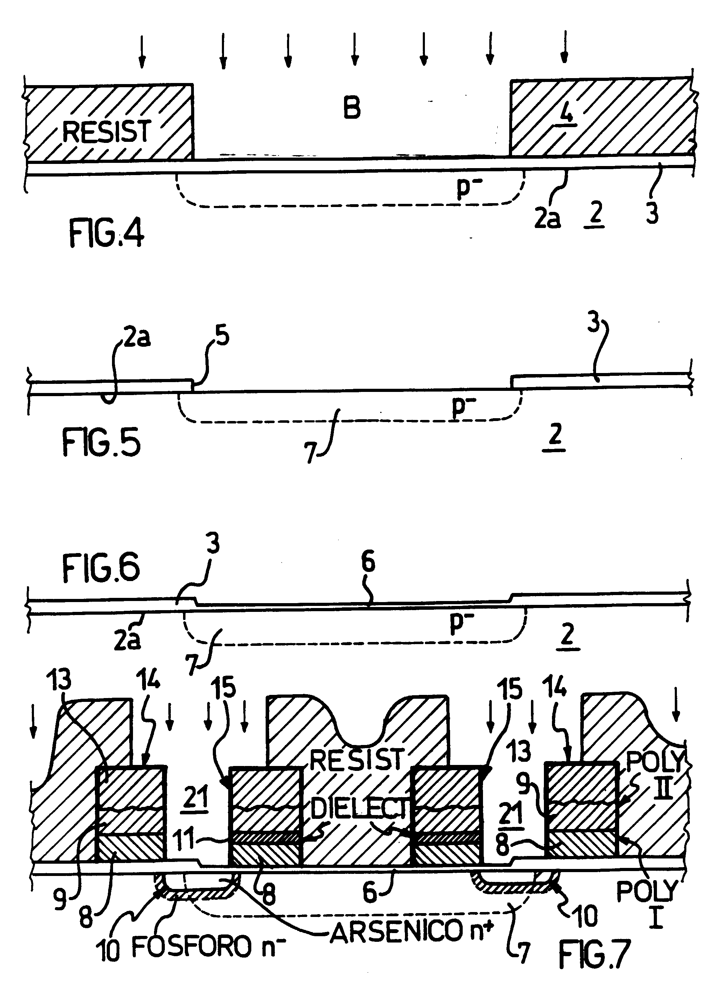

Provided over the floating gate 12 between the first 8 and second 9 polysilicon layers, is the interpoly dielectric layer 11. Using a photolithographic technique, respective apertures 21 are defined, throughout the layers 13, 9, 11 and 8, as far as the oxide layers 3 and 6, as shown in Figure 7. These apertures 21 are cut between the respective gate terminals of each cell 1 and each selection transistor 14 associated therewith.

A subsequent step of double ion implantation yields regions 10 which have two different concentrations of the same dopant type.

Specifically, an implantation followed by diffusion of Phosphorus ions enables a first region 18 doped N- to be defined. This first region 18 will receive a second region 19 to be formed by implantation and successive diffusion with Arsenic ions.

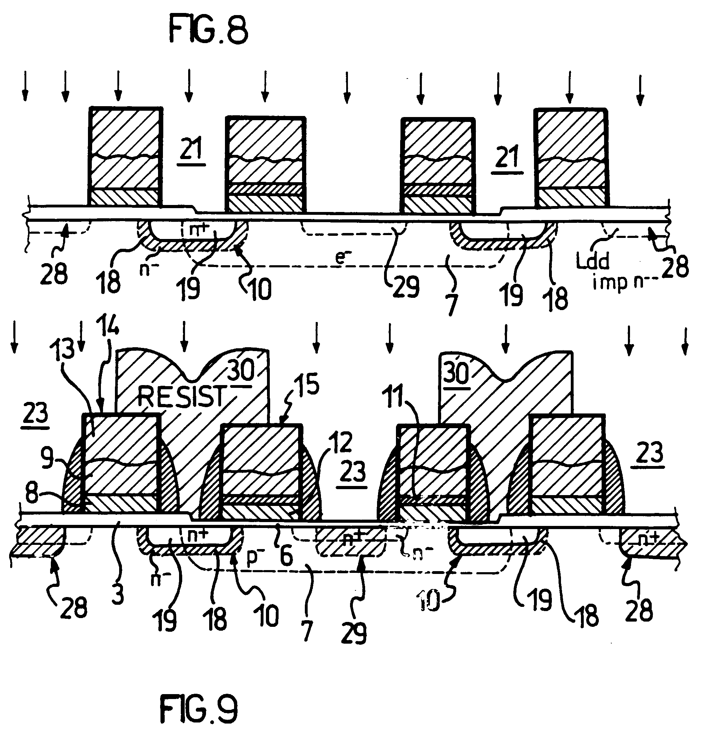

This second Arsenic implant is at a greater concentration than the previous Phosphorus implant, and the region 19 will have a concentration of dopant of the N+ type. The concentration gradient of the dopant N between the regions 18 and 19 lowers the so-called tunneling of the band-to-band current during the cell "write" phase. Similarly, shown schematically in Figure 8 are the implantation steps which also enable the active drain and source areas 28 and 29 to be doped.

Advantageously, this process step is carried out using a technique known as LDD (Low Density Diffusion) at a low dopant concentration.

Both the drain area 28 and source area 29 of the transistor comprising the cell 1 are denoted by the reference character (f) in Figure 1 and circumscribed by respective dash-and-dot lines.

At this stage, so-called spacers 27 are formed, and by masking with a photoresist 30, also the apertures 21 for removing the silicide 13 and oxide 9 layers from above the source 29 and the drain regions 28 at the sides of the selection transistors 14.

This step allows fresh apertures 23 to be opened through which an implantation is carried out with Arsenic N+ ions to complete the doping of the active areas 28 and 29, as shown in Figure 9.

The process steps are completed with the deposition of a passivating layer 24 and the provision of the final metallization layer 26. These, the very last, steps of the process are carried out in a conventional manner.

The method for programming the memory cell of this invention will now be described. In fact, the peculiarly innovative structure of this cell 1 allows it to be programmed in quite unique a manner.

For cell writing and erasing in conventional storage circuits, positive voltage pulses are applied to the cell terminals in order to generate a sufficient electric field to cause a current flow through the tunnel oxide layer.

By contrast, in the cell 1, according to the method of this invention, a negative voltage is used for application to the control gate 15 during the write phase.

Shown by way of example in the following Table are the values of the voltages to be applied across the cell 1. For each of the write, erase and read phases, there are specified the voltage values at the control gate 12, the bit line (drain contact), word line (gate of the selection transistor 14), and source diffusion 29.

**TABLE:**

| | P.C. | B.L. | W.L. | Source |
|---|---|---|---|---|
| WRITE | -8 V | 5 V | 7 V | floating |
| | | | | |
| ERASE | 15 V | 0 V | floating | floating |
| | | | | |
| READ | 5 V | 1 V | 5 V | 0 V |

When such negative voltage is used, the voltage being applied to the drain terminal can be reduced while retaining through the thin oxide 6 an electric field of the same level as in conventional cells.

This will reduce the maximum energy of the so-called holes generated by the band-to-band current at the junction of the drain region. Accordingly, the deterioration of the thin tunnel oxide can be greatly reduced.

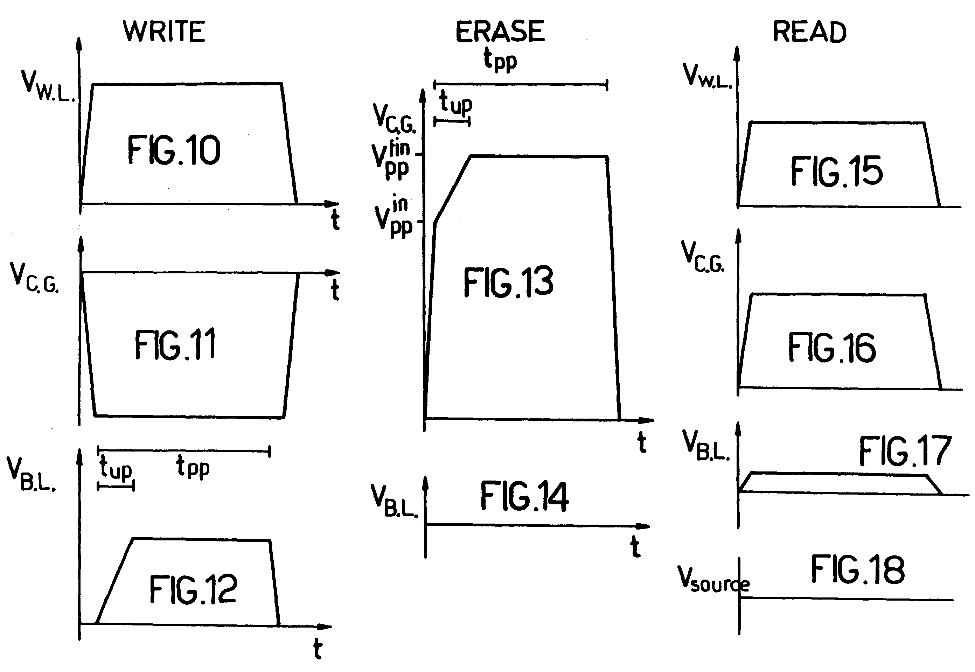

As shown in Figures 10 to 18, the programming impulses applied during the write phase to the drain contact, or applied during the erase phase to the control gate, are characterized by a rise speed that, in conjunction with the applied voltage values, will set the maximum current level through the thin oxide 6. By controlling this rise speed, the overall reliability of the cell can be improved while lowering the tunnel oxide stress.

In fact, during the write phase, control of the rise speed of the impulse on the bit line is effective to keep the electric field being applied across the tunnel oxide 6 constant over time. In this way the breakdown phenomenon attendant to the gate terminal voltage can be also controlled. In a similar way, during the erase phase, control of the rise speed values of the impulse at the control gate 15 enables the electric field being applied across the tunnel oxide 6 to be kept constant over time.

For completeness of discussion, it should be noted that it is only during the write phase that all the memory cells in one and the same word line could undergo stress from the negative voltage. This because the cells are applied an electric field tending to deteriorate the informational content thereof.

However, this possible shortcoming can be fully controlled by suitable adjustment of the negative voltage value.

In this respect, in actual tests, using a programming time of 5 msec, durations of at least 100 k programming cycles have been obtained with no performance deterioration and no significant loss of information from the programming of other cells in the same row or domain of the cell matrix.

The memory cell suitable for this invention does solve the technical problem, and affords a number of advantages as specified herein below.

The peculiar structure of the cell 1 allows it to be compacted, for a given technology, within an area which is less than one half that occupied by a conventional two-level polysilicon cell.

The use of a negative voltage to the control gate 15 of the cell, during the write phase, allows the required voltage across the tunnel oxide 6 to be distributed so as to provide the programming current sought. This also enables a standard selection transistor 14 to be used, and the use of a high voltage transistor avoided. In fact, the voltage which is transferred to the drain region of the cell is substantially on the order of 4-6 Volts.

The use of a suitable rise speed for the write and erase impulses allows the maximum current level through the tunnel oxide to be controlled and kept constant over time. Thus, the cell performance and long-term reliability can be improved by that the deterioration is reduced of the thin silicon oxide 6 subjected to the tunnel effect.

Also, the oxide deterioration problems which are typical of the Flash-type memory cells can be much attenuated.

In view of that the operation of the cell is based on a Fowler-Nordheim tunnel effect and that its inherent threshold can be selected close to zero, the instant structure will specially suit low supply voltage applications, even ones as low as 3 Volts.

The overall electric length of the cell is greater than that of a Flash cell, and in addition:
- the diffusion of Phosphorus through the drain region is much reduced because channel doping is slight, whereby the voltages applied to the drain can be small, on the order of 4-6 Volts;
- with the source being formed by the LDD method, the heavy Arsenic implant, peripherally of the source and the drain regions, can be held away from the cell gate.

The last-mentioned features of the cell foster very large scale integration of the cell, increasing its effective electric length and allowing it to be scaled down to uniquely small sizes.

## Claims

1. A method of programming a two-level polysilicon EEPROM memory cell, said cell (1) being implemented in MOS technology on a semiconductor substrate (2) with a floating gate (12) transistor overlying a thin tunnel oxide layer (6) and having a further control gate (15) overlying the floating gate (12), with a dielectric layer (11) therebetween, and being connected serially to a selection transistor (14), said cell including active regions (28, 29) formed by a double implant realized with two different concentrations of the same conductivity type, wherein a negative voltage is applied to said control gate (15) during the cell (1) write phase, while a positive voltage is applied to one (28) of said active regions so that the voltage applied accross the thin tunnel oxide layer is distributed.

2. A programming method according to Claim 1, characterized in that the value of said negative voltage is set on the basis of the desired electric field across the tunnel oxide layer (6) underlying the floating gate (12).

3. A programming method according to Claim 1, characterized in that the voltages applied across the cell during the write, erase and read phases are setaccording to the following chart:
| | P.C. | B.L. | W.L. | Source |
|---|---|---|---|---|
| WRITE | -8 V | 5 V | 7 V | floating |
| | | | | |
| ERASE | 15 V | 0 V | floating | floating |
| | | | | |
| READ | 5 V | 1 V | 5 V | 0 V |
where: P.C. identifies the control gate (15) terminal of the cell, B.L. (Bit Line) identifies the drain terminal of the cell, and W.L. (Word Line) identifies the gate terminal of the selection transistor (14).

4. A programming method according to Claim 1, characterized in that the voltage impulses applied to the drain region and the control gate during the write and erase phases, respectively, have a rise speed which is predetermined on the basis of the maximum current that is to flow through the thin oxide (6).

## Patentansprüche

1. Verfahren zum Programmieren einer Polysilizium-EEPROM-Speicherzelle mit zwei Ebenen, wobei die Zelle (1) in MOS-Technologie auf einem Halbleitersubstrat (2) ausgeführt ist, wobei ein ein schwebendes Gate (12) aufweisender Transistor über einer dünnen Tunneloxidschicht (6) angeordnet ist und ein weiteres Steuergate (15) aufweist, das unter Zwischenanordnung einer dielektrischen Schicht (11) über dem schwebenden Gate (12) angeordnet ist, sowie mit einem Auswähltransistor (14) in Reihe geschaltet ist, wobei die Zelle aktive Bereiche (28, 29) aufweist, die durch eine Doppel-Implantation gebildet sind, die mit zwei verschiedenen Konzentrationen desselben Leitfähigkeits-Typs realisiert wird,
wobei während der Schreibphase der Zelle (1) eine negative Spannung an das Steuergate (15) angelegt wird, während eine positive Spannung an einen (28) der aktiven Bereiche angelegt wird, so daß die über der dünnen Tunneloxidschicht anliegende Spannung verteilt wird.

2. Programmierverfahren nach Anspruch 1,
dadurch gekennzeichnet, daß der Wert der negativen Spannung auf der Basis des gewünschten elektrischen Felds über der unter dem schwebenden Gate (12) liegenden Tunneloxidschicht (6) festgelegt wird.

3. Programmierverfahren nach Anspruch 1,
dadurch gekennzeichnet, daß die während der Phasen Schreiben, Löschen und Lesen über der Zelle angelegten Spannungen entsprechend der nachfolgenden Auflistung festgelegt werden:
| | P.C. | B.L. | W.L. | Source |
|---|---|---|---|---|
| SCHREIBEN | -8 V | 5 V | 7 V | schwebend |
| LÖSCHEN | 15 V | 0 V | schwebend | schwebend |
| LESEN | 5 V | 1 V | 5 V | 0 V |
wobei: P.C. den Anschluß des Steuergates (15) der Zelle bezeichnet, B.L. (Bitleitung) den Drain-Anschluß der Zelle bezeichnet und W.L. (Wortleitung) den Gateanschluß des Auswähltransistors (14) bezeichnet.

4. Programmierverfahren nach Anspruch 1,
dadurch gekennzeichnet, daß die während der Schreib- und der Löschphase an den Drain-Bereich bzw. das Steuergate angelegten Spannungsimpulse eine Anstiegsgeschwindigkeit besitzen, die auf der Basis des maximalen Stroms, der durch das dünne Oxid (6) fließen soll, festgelegt wird.

## Revendications

1. Procédé de programmation d'une cellule de mémoire EEPROM à double couche de polysilicium, ladite cellule (1) étant réalisée par une technique MOS sur un substrat semiconducteur (2) avec un transistor à grille flottante (12) recouvrant une couche mince d'oxyde de grille (6) et ayant une autre grille de commande (15) recouvrant la grille flottante (12), avec une couche diélectrique (11) entre celles-ci, et étant connectée en série à un transistor de sélection (14), ladite cellule comprenant des zones actives (28, 29) formées par une double implantation réalisée avec deux concentrations différentes du même type de conductivité, dans lequel une tension négative est appliquée à ladite grille de commande (15) durant la phase d'écriture dans la cellule (1), tandis qu'une tension positive est appliquée à l'une (28) desdites zones actives, de sorte que la tension appliquée à travers la couche mince d'oxyde de grille est distribuée.

2. Procédé de programmation selon la revendication 1, caractérisé en ce que la valeur de ladite tension négative est fixée sur la base du champ électrique souhaité à travers la couche d'oxyde de grille (6) sous-jacente à la grille flottante (12).

3. Procédé de programmation selon la revendication 1, caractérisé en ce que les tensions appliquées à travers la cellule durant les phases d'écriture, d'effacement et de lecture sont réglées selon le tableau suivant :
| | P.C. | B. L. | W. L. | Source |
|---|---|---|---|---|
| ECRITURE | - 8 V | 5 V | 7 V | flottante |
| EFFACEMENT | 15 V | 0 V | flottante | flottante |
| LECTURE | 5 V | 1 V | 5 V | 0 V |
dans lequel : P.C. identifie la borne de la grille de commande (15) de la cellule, B.L. (Ligne de Bit) identifie la borne de drain de la cellule et W.L. (Ligne de Mots) identifie la borne de grille du transistor de sélection (14).

4. Procédé de programmation selon la revendication 1, caractérisé en ce que les impulsions de tension appliquées à la zone de drain et à la grille de commande durant les phases d'écriture et d'effacement, respectivement, ont une vitesse de montée qui est prédéterminée sur la base du courant maximal qui doit s'écouler à travers la couche d'oxyde mince (6).
